# EUROPEAN PATENT APPLICATION

(11) **EP 4 848 332 A1**
(43) Date of publication of application: **02.12.2026**
(21) Application number: 25745048.6
(22) Date of filing: 21.01.2025
(51) Int. Cl.: H01L 21/306, H01L 21/304

(54) **SUBSTRATE PROCESSING APPARATUS AND SUBSTRATE PROCESSING METHOD**

(30) Priority: 26.01.2024 JP 2024010075
(71) Applicant: SCREEN Holdings Co., Ltd., Kyoto-shi, Kyoto 602-8585 (JP)
(72) Inventor: KAMMURI, Takuya, Kyoto-shi, Kyoto 602-8585 (JP); MATSUNAGA, Kaho, Kyoto-shi, Kyoto 602-8585 (JP); OKAMOTO, Koichi, Kyoto-shi, Kyoto 602-8585 (JP); ISHIZU, Takaaki, Kyoto-shi, Kyoto 602-8585 (JP)
(74) Representative: Kilian Kilian & Partner mbB
(86) International application number: PCT/JP2025/001671
(87) International publication number: WO 2025/159064

(57) **Abstract**

The substrate processing apparatus includes a substrate holding unit, a substrate rotating unit, a first nozzle, and a second nozzle. The substrate holding unit horizontally holds a substrate. The substrate rotating unit rotates the substrate and the substrate holding unit together. The first nozzle discharges an etching liquid toward the substrate rotating while being held by the substrate holding unit. The second nozzle discharges a rinse liquid toward the substrate rotating while being held by the substrate holding unit to remove the etching liquid from the substrate. The etching liquid contains an organic solvent and a chemical liquid. The rinse liquid contains an organic dissolving agent and water. The organic dissolving agent has higher affinity for the organic solvent than the water does.

## Description

### TECHNICAL FIELD

The present invention relates to a substrate processing apparatus and a substrate processing method.

### BACKGROUND ART

Patent Literature 1 discloses a substrate processing apparatus of single-substrate processing type adapted to etch a substrate having a pattern formed on the upper surface thereof. The substrate processing apparatus of Patent Literature 1 supplies an etching liquid onto the upper surface of the substrate to remove native oxide from the substrate, and then supplies a rinse liquid onto the upper surface of the substrate to remove the etching liquid from the substrate. The substrate processing apparatus of Patent Literature 1 supplies hydrofluoric acid (HF) as the etching liquid onto the substrate, and supplies deionized water (DIW) as the rinse liquid onto the substrate.

### RELATED ART DOCUMENT

### Citation List

Patent Literature 1: Japanese Patent Application Publication No. 2023-136723

### SUMMARY OF INVENTION

### PROBLEM TO BE SOLVED BY INVENTION

In recent years, however, the scaling down of patterns to be formed on substrates has been increasingly accelerated. Therefore, further improvement is required to ensure stable infiltration of the etching liquid into deep parts of fine patterns.

It is an object of the present invention to provide a substrate processing apparatus and a substrate processing method that ensure the stable infiltration of the etching liquid into the deep parts of the patterns.

### SOLUTION TO PROBLEM

According to one aspect of the present invention, the substrate processing apparatus includes a substrate holding unit, a substrate rotating unit, a first nozzle, and a second nozzle. The substrate holding unit horizontally holds a substrate. The substrate rotating unit rotates the substrate and the substrate holding unit together. The first nozzle discharges an etching liquid toward the substrate rotating while being held by the substrate holding unit. The second nozzle discharges a rinse liquid toward the substrate rotating while being held by the substrate holding unit to remove the etching liquid from the substrate. The etching liquid contains an organic solvent and a chemical liquid. The rinse liquid contains an organic dissolving agent and water. The organic dissolving agent has higher affinity for the organic solvent than the water does.

In one embodiment, the organic solvent is water-insoluble.

In another embodiment, the organic solvent has a smaller relative dielectric constant than the chemical liquid.

In further another embodiment, the etching liquid contains, as the organic solvent, a first organic solvent and a second organic solvent different from the first organic solvent. The first organic solvent and the second organic solvent have different relative dielectric constants.

In still another embodiment, the etching liquid further contains a surfactant.

In further another embodiment, the etching liquid further contains an additive that increases the hydrogen ion concentration of the etching liquid.

In still another embodiment, the chemical liquid is an acidic chemical liquid.

In further another embodiment, the etching liquid contains, as the chemical liquid, a first chemical liquid and a second chemical liquid different from the first chemical liquid. The first chemical liquid and the second chemical liquid are both acidic chemical liquids.

In still another embodiment, the concentration of the organic dissolving agent in the rinse liquid is not lower than 25%.

In further another embodiment, the substrate processing apparatus further includes a first liquid pipe, a second liquid pipe, a third liquid pipe, a flow rate regulation valve, and a controller. The first liquid pipe supplies the rinse liquid to the second nozzle. The second liquid pipe supplies the water to the first liquid pipe. The third liquid pipe supplies the organic dissolving agent to the first liquid pipe. The flow rate regulation valve is provided in the third liquid pipe. The flow rate regulation valve regulates the flow rate of the organic dissolving agent to be supplied to the first liquid pipe from the third liquid pipe. The controller controls the flow rate regulation valve to adjust the concentration of the organic dissolving agent in the rinse liquid. The controller controls the flow rate regulation valve so that the concentration of the organic dissolving agent is lower at the end of the discharge of the rinse liquid from the second nozzle than at the start of the discharge of the rinse liquid from the second nozzle.

In still another embodiment, the controller controls the flow rate regulation valve so that the concentration of the organic dissolving agent is reduced stepwise or gradually during the discharge of the rinse liquid.

In further another embodiment, the substrate processing apparatus further includes an open/close valve. The open/close valve is provided in the third liquid pipe. The open/close valve starts and stops supply of the organic dissolving agent from the third liquid pipe to the first liquid pipe. The controller controls the open/close valve to stop the supply of the organic dissolving agent during the discharge of the rinse liquid.

According to another aspect of the present invention, the substrate processing method includes: a substrate holding step of horizontally holding a substrate; a substrate rotating step of rotating the substrate; an etching step of discharging an etching liquid from a first nozzle toward the rotating substrate; and a rinsing step of discharging a rinse liquid from a second nozzle toward the rotating substrate held to remove the etching liquid from the substrate. The etching liquid contains an organic solvent and a chemical liquid. The rinse liquid contains an organic dissolving agent and water. The organic dissolving agent has higher affinity for the organic solvent than the water does.

In one embodiment, the rinsing step includes: a step of supplying the water to a liquid pipe to supply the rinse liquid to the second nozzle; a step of supplying the organic dissolving agent to the liquid pipe; and a concentration adjusting step of regulating the flow rate of the organic dissolving agent to be supplied to the liquid pipe so that the concentration of the organic dissolving agent is lower at the end of the discharge of the rinse liquid from the second nozzle than at the start of the discharge of the rinse liquid from the second nozzle.

In another embodiment, the flow rate of the organic dissolving agent is regulated so that the concentration of the organic dissolving agent is reduced stepwise or gradually during the discharge of the rinse liquid in the concentration adjusting step.

In further another embodiment, the substrate processing method further includes a step of stopping the supply of the organic dissolving agent to the liquid pipe during the discharge of the rinse liquid.

According to at least one of the aspects of the present invention, the etching liquid can be stably infiltrated into deep parts of patterns.

### BRIEF DESCRIPTION OF DRAWINGS

FIG. 1 is a schematic diagram of a substrate processing apparatus according to an embodiment of the present invention.
FIG. 2 is a sectional view schematically showing the structure of a substrate treatment unit included in the substrate processing apparatus according to the embodiment of the present invention.
FIG. 3 is a diagram showing the structure of a part of the substrate processing apparatus according to the embodiment of the present invention.
FIG. 4 is a diagram showing the structure of a part of the substrate processing apparatus according to the embodiment of the present invention by way of another example.
FIG. 5 is a diagram showing the structure of another part of the substrate processing apparatus according to the embodiment of the present invention.
FIG. 6 is a flowchart showing a substrate processing method according to the embodiment of the present invention.
FIG. 7 is a flowchart showing a rinsing step by way of example.
FIG. 8 is a diagram showing the flow rate of a rinse liquid by way of example.
FIG. 9 is a diagram showing the flow rate of the rinse liquid by way of another example.

### EMBODIMENTS OF INVENTION

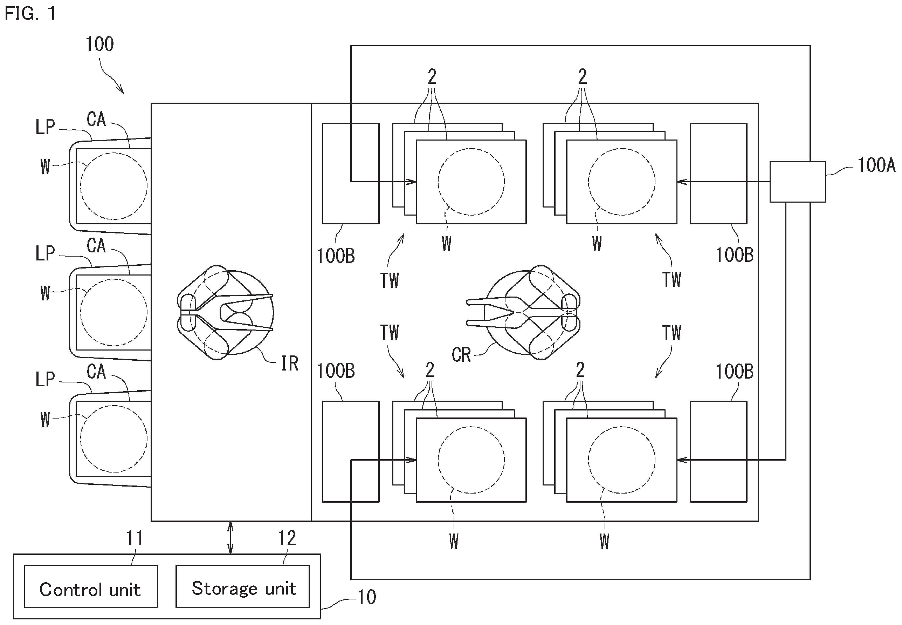

With reference to the drawings (FIGS. 1 to 9), a substrate processing apparatus and a substrate processing method will hereinafter be described according to embodiments of the present invention. However, the present invention is not limited to the following embodiments, but various modifications can be made without departing from the scope of the present invention. Duplicate description will be omitted if appropriate. Further, like or corresponding components will be denoted by like reference characters, and redundant description thereof will be omitted.

Applicable examples of "substrate" to be processed in the substrate processing apparatus and the substrate processing method according to the present invention include semiconductor wafers, glass substrates for photomasks, glass substrates for liquid crystal display, glass substrates for plasma display, substrates for FED (Field Emission Display), substrates for optical disks, substrates for magnetic disks, substrates for magneto-optical disks, and other various substrates. Hereinafter, the embodiments of the present invention will be described mainly for substrate processing to be performed on disk-shaped semiconductor wafers by way of example, but the substrate processing apparatus and the substrate processing method according to the present invention are applicable likewise to various substrates other than the semiconductor wafers. Further, the shapes of the substrates are not limited to the disk shape, but the substrate processing apparatus and the substrate processing method according to the present invention are applicable to various shapes of the substrates.

FIG. 1 is a schematic diagram of a substrate processing apparatus 100 of this embodiment. Specifically, FIG. 1 is a schematic plan view of the substrate processing apparatus 100 of this embodiment. The substrate processing apparatus 100 is an apparatus of a single-substrate processing type adapted to process substrates W one by one. More specifically, the substrate processing apparatus 100 is an etching apparatus adapted to etch the substrates W one by one.

As shown in FIG. 1, the substrate processing apparatus 100 includes a plurality of substrate treatment units 2, a fluid cabinet 100A, a plurality of fluid boxes 100B, a plurality of load ports LP, an indexer robot IR, a center robot CR, and a controller 10.

Cassettes CA are respectively placed on the load ports LP. The cassettes CA each accommodate a plurality of substrates W stacked one on another. For example, the cassettes CA may be each a FOUP (Front Opening Unified Pod), a SMIF (Standard Mechanical Interface) Pod or an OC (Open Cassette).

The indexer robot IR transports a substrate W between the cassettes CA and the center robot CR. The center robot CR transports a substrate W between the indexer robot IR and the substrate treatment units 2. A placement stand (pass) on which a substrate W is temporarily placed may be provided between the indexer robot IR and the center robot CR, and the apparatus may be configured so that the substrate W can be transferred between the indexer robot IR and the center robot CR indirectly via the placement stand.

The substrate treatment units 2 constitute a plurality of towers TW (four towers TW in FIG. 1). The towers TW are disposed around the center robot CR as seen in plan. The towers TW each include a plurality of substrate treatment units 2 (three substrate treatment units 2 in FIG. 1) vertically stacked one on another.

The fluid cabinet 100A accommodates treatment liquids. The treatment liquids include an etching liquid and constituents of a rinse liquid. The etching liquid contains at least a chemical liquid and an organic solvent.

Specifically, the chemical liquid can be an acidic chemical liquid. For example, the chemical liquid can be a chemical liquid containing hydrogen fluoride. For example, the chemical liquid may be hydrofluoric acid (HF) or may be diluted hydrofluoric acid (DHF). The diluted hydrofluoric acid indicates hydrofluoric acid having a dilute concentration (e.g., of about 0.01% by weight). The etching liquid may contain two or more kinds of chemical liquids. For example, the etching liquid may contain, as the chemical liquid, a first chemical liquid and a second chemical liquid different from the first chemical liquid. The first chemical liquid and the second chemical liquid may be both acidic chemical liquids. For example, the etching liquid may contain, as the chemical liquid, diluted hydrofluoric acid and hydrochloric acid (HCl).

For example, the organic solvent can be water-insoluble. The organic solvent preferably has a smaller relative dielectric constant than the chemical liquid. The organic solvent may be, for example, PGMEA (propylene glycol monomethyl ether acetate). PGMEA is an example of the water-insoluble organic solvent. Further, PGMEA is an example of the organic solvent having a smaller relative dielectric constant than the chemical liquid. The relative dielectric constant of PGMEA is 8.3.

The etching liquid may contain two or more kinds of organic solvents. For example, the etching liquid may contain, as the organic solvent, a first organic solvent and a second organic solvent different from the first organic solvent. The first organic solvent and the second organic solvent may have different relative dielectric constants. For example, the etching liquid may contain, as the organic solvent, PGMEA and PGME (propylene glycol monomethyl ether).

The etching liquid may further contain a surfactant, or may further contain an additive that increases the hydrogen ion concentration of the etching liquid. The surfactant may be, for example, IPA (isopropyl alcohol). For example, the additive may be perchloric acid (HClO₄), hydrogen iodide (HI), hydrogen bromide (HBr), hydrogen chloride (HCl), sulfuric acid (H₂SO₄), nitric acid (HNO₃), hydronium (H₃O⁺), oxalic acid (HO₂C₂O₂H), sulfurous acid (H₂SO₃), hydrogen sulfate ion (HSO₄⁻) or phosphoric acid (H₃PO₄).

The constituents of the rinse liquid include water and an organic dissolving agent. That is, the rinse liquid contains the water and the organic dissolving agent.

Specifically, the water can be deionized water (DIW). The deionized water is a kind of so-called ultrapure water. However, the water is not limited to the deionized water. For example, the water can be carbonated water, electrolytic ion water, hydrogen water, ozone water, ammonia water or hydrochloric acid water having a dilute concentration (e.g., of about 0.001% by weight to about 0.01% by weight).

An organic dissolving agent that has higher affinity for the organic solvent of the etching liquid than the water does is used as the organic dissolving agent. Specifically, the organic dissolving agent can be an organic compound having a polar group. For example, the organic dissolving agent may be isopropyl alcohol (IPA). Alternatively, the organic dissolving agent may be ethanol, methanol or acetone. The concentration of the organic dissolving agent in the rinse liquid is not lower than 25%.

The fluid boxes 100B each correspond to one of the towers TW. The treatment liquids in the fluid cabinet 100A are supplied to all the substrate treatment units 2 included in the corresponding tower TW via the corresponding fluid box 100B.

The substrate treatment units 2 each treat a single substrate W at a time. Specifically, the substrate treatment units 2 each perform an etching process, a rinsing process and a drying process on the substrate W.

The controller 10 is configured or programmed to control the operations of the components of the substrate processing apparatus 100. For example, the controller 10 controls the substrate treatment units 2, the load ports LP, the indexer robot IR and the center robot CR. The controller 10 includes a control unit 11 and a storage unit 12.

The control unit 11 controls the operations of the components of the substrate processing apparatus 100 based on various information stored in the storage unit 12. The control unit 11 has, for example, a processor. The control unit 11 may have, as the processor, a CPU (Central Processing Unit) or a MPU (Micro Processing Unit). Alternatively, the control unit 11 may have a general-purpose computer or a dedicated computer.

The storage unit 12 stores various information for the control of the operations of the substrate processing apparatus 100. For example, the storage unit 12 stores various data and various computer programs. The data includes recipe data. The recipe data indicates recipes specifying the processing contents, the processing conditions and the processing procedures for the processing of the substrates W. In the recipes, various setting values are set for the processing conditions.

The storage unit 12 has a main storage unit. The main storage unit includes, for example, a semiconductor memory. The storage unit 12 may further have an auxiliary storage unit. The auxiliary storage unit includes, for example, at least one of a semiconductor memory and a hard disk drive. The storage unit 12 may include removable media.

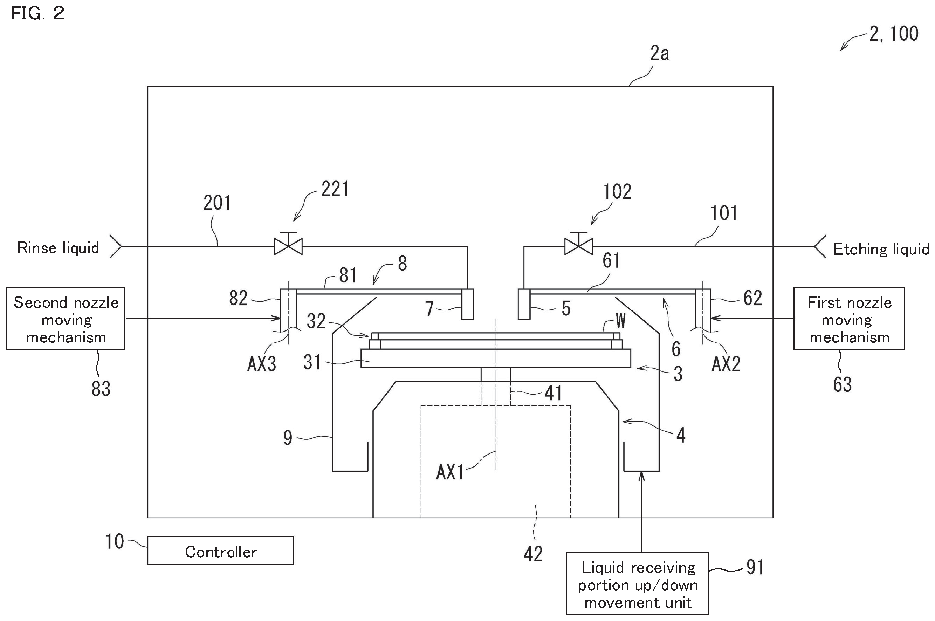

Referring next to FIG. 2, the substrate processing apparatus 100 of this embodiment will be described. FIG. 2 is a sectional view schematically showing the structure of the substrate treatment unit 2 included in the substrate processing apparatus 100 of this embodiment.

As shown in FIG. 2, the substrate treatment unit 2 has a chamber 2a, a substrate holding unit 3, a substrate rotating unit 4, a first nozzle 5, a first nozzle moving unit 6, a second nozzle 7, a second nozzle moving unit 8, a liquid receiving portion 9, and a liquid receiving portion up/down movement unit 91. The substrate processing apparatus 100 further includes an etching liquid pipe 101, an etching liquid open/close valve 102, a first rinse liquid pipe 201, and a first rinse liquid open/close valve 221.

The chamber 2a has a generally box shape. The chamber 2a accommodates the substrate holding unit 3, the substrate rotating unit 4, the first nozzle 5, the first nozzle moving unit 6, the second nozzle 7, the second nozzle moving unit 8, the liquid receiving portion 9, a part of the etching liquid pipe 101, and a part of the first rinse liquid pipe 201. The rest of the etching liquid pipe 101 is accommodated in the fluid box 100B described with reference to FIG. 1. Similarly, the rest of the first rinse liquid pipe 201 is accommodated in the fluid box 100B described with reference to FIG. 1.

The substrate W is loaded into the chamber 2a by the center robot CR described with reference to FIG. 1. Therefore, the chamber 2a accommodates the substrate W. The substrate W is treated within the chamber 2a, and then unloaded out of the chamber 2a by the center robot CR described with reference to FIG. 1.

The substrate holding unit 3 is a substrate holder that holds the substrate W in a horizontal attitude. As shown in FIG. 2, the substrate holding unit 3 may have a spin base 31 and a plurality of chuck members 32. The spin base 31 has a generally disk shape, and supports the chuck members 32 in a horizontal attitude. The chuck members 32 are disposed on the peripheral portion of the spin base 31. The chuck members 32 clamp the peripheral portion of the substrate W. The substrate W is held in the horizontal attitude by the chuck members 32. The operation of the chuck members 32 is controlled by the controller 10 (control unit 11).

The substrate rotating unit 4 is a substrate rotator that rotates the substrate holding unit 3 and the substrate W together about a first rotation axis AX1 extending vertically. The controller 10 (control unit 11) controls the rotation of the substrate W by the substrate rotating unit 4. Specifically, the first rotation axis AX1 extends through the center of the spin base 31. The chuck members 32 are disposed so that the center of the substrate W is opposed to the center of the spin base 31. Therefore, the substrate W is rotated about the center of the substrate W.

As shown in FIG. 2, the substrate rotating unit 4 may have a shaft 41 and a motor main body 42. The shaft 41 is connected to the center of the spin base 31, and projects downward from the spin base 31 along the first rotation axis AX1. The motor main body 42 rotates the shaft 41. As a result, the spin base 31 is rotated. The operation of the motor main body 42 is controlled by the controller 10 (control unit 11).

The first nozzle 5 discharges the etching liquid toward the substrate W rotating while being held by the substrate holding unit 3. Specifically, the first nozzle 5 discharges the etching liquid from above the substrate W toward the upper surface of the rotating substrate W. By discharging the etching liquid onto the upper surface of the rotating substrate, a liquid film of the etching liquid is formed on the upper surface of the substrate W. As a result, the upper surface of the substrate W is treated with the etching liquid.

Specifically, a pattern is provided in the upper surface of the substrate W. For example, the pattern is formed on the upper surface of the substrate W by a dry etching process. The pattern includes a nitride film and an oxide film. The oxide film includes native oxide. In this example, the oxide film of the pattern is etched with the etching liquid. However, the nitride film is also slightly etched with the etching liquid. That is, the etch rate of the nitride film is lower than the etch rate of the oxide film.

In this embodiment, as previously described, the etching liquid contains the chemical liquid and the organic solvent. Therefore, wettability with the etching liquid is improved as compared with a case in which the etching liquid does not contain the organic solvent. As a result, even with the substrate W formed with a fine pattern, the etching liquid can be stably infiltrated into deep parts of the pattern. This makes it possible to stably remove the oxide film from the entire pattern. Since the oxide film can be removed from the entire pattern, the electrical characteristics of devices produced from the substrate W can be improved as compared with the case in which the etching liquid does not contain the organic solvent.

In this embodiment, as previously described, the organic solvent has a smaller relative dielectric constant than the chemical liquid. As a result, the etching (stripping) of the nitride film is suppressed as compared with the case in which the etching liquid does not contain the organic solvent having a smaller relative dielectric constant. Thus, the etching selectivity can be improved.

The etching liquid pipe 101 supplies the etching liquid to the first nozzle 5. The etching liquid pipe 101 is a tubular member through which liquid flows.

The etching liquid open/close valve 102 is provided in the etching liquid pipe 101. The etching liquid open/close valve 102 is accommodated in the fluid box 100B described with reference to FIG. 1. The etching liquid open/close valve 102 can be switched between an open state and a closed state. The controller 10 (control unit 11) controls the open/close operation of the etching liquid open/close valve 102. An actuator for the etching liquid open/close valve 102 is, for example, an electric actuator or a pneumatic actuator.

The etching liquid open/close valve 102 starts and stops flow of the etching liquid through the etching liquid pipe 101. In other words, the etching liquid open/close valve 102 starts and stops supply of the etching liquid to the first nozzle 5.

The controller 10 (control unit 11) sets the etching liquid open/close valve 102 in the open state when the etching liquid is to be discharged from the first nozzle 5. As a result, the etching liquid flows through the etching liquid pipe 101 toward the first nozzle 5, and is discharged from the first nozzle 5 toward the substrate W.

The controller 10 (control unit 11) sets the etching liquid open/close valve 102 in the closed state when the discharge of the etching liquid from the first nozzle 5 is to be stopped. As a result, the flow of the etching liquid through the etching liquid pipe 101 is stopped, and the discharge of the etching liquid from the first nozzle 5 is stopped.

The first nozzle moving unit 6 moves the first nozzle 5 vertically and horizontally. The first nozzle moving unit 6 is controlled by the controller 10 (control unit 11). As shown in FIG. 2, the first nozzle moving unit 6 may have a first nozzle arm 61, a first nozzle base 62 and a first nozzle moving mechanism 63.

The first nozzle base 62 extends vertically. The proximal end of the first nozzle arm 61 is connected to the first nozzle base 62. The first nozzle arm 61 extends horizontally from the first nozzle base 62. The first nozzle arm 61 supports the first nozzle 5. The first nozzle 5 projects vertically downward from the first nozzle arm 61.

The first nozzle moving mechanism 63 moves the first nozzle arm 61 vertically and horizontally. As a result, the first nozzle 5 is moved vertically and horizontally. The first nozzle moving mechanism 63 is controlled by the controller 10 (control unit 11). Specifically, the first nozzle moving mechanism 63 has a rotation mechanism and a lift mechanism.

The rotation mechanism of the first nozzle moving mechanism 63 rotates the first nozzle base 62 in forward and reverse directions about a second rotation axis AX2 extending vertically. As a result, the first nozzle 5 is moved along a horizontal plane. The lift mechanism of the first nozzle moving mechanism 63 vertically moves the first nozzle base 62 up and down in the vertical direction. As a result, the first nozzle 5 is moved vertically. An actuator for the rotation mechanism may have, for example, a servomotor such as a stepping motor, and a decelerator. An actuator for the lift mechanism may have, for example, a ball screw and an electric motor rotatable in forward and reverse directions.

Specifically, the first nozzle moving unit 6 moves the first nozzle 5 between a first retraction position and a treatment position. The first retraction position is a position outward of the liquid receiving portion 9. In this embodiment, the treatment position is a position opposed to the center of the substrate W. The first nozzle 5 discharges the etching liquid from the treatment position toward the upper surface of the substrate W.

The second nozzle 7 discharges the rinse liquid toward the substrate W rotating while being held by the substrate holding unit 3 to remove the etching liquid from the substrate W after the discharge of the etching liquid from the first nozzle 5 is stopped. Specifically, the second nozzle 7 discharges the rinse liquid from above the substrate W toward the upper surface of the substrate W . By discharging the rinse liquid toward the upper surface of the substrate W, the etching liquid is removed from the upper surface of the substrate W and a liquid film of the rinse liquid is formed. That is, the liquid film of the etching liquid is replaced with the liquid film of the rinse liquid on the substrate W.

As previously described, the rinse liquid contains the organic dissolving agent and the water. The organic dissolving agent of the rinse liquid has higher affinity for the organic solvent of the etching liquid than the water of the rinse liquid does. Therefore, the organic solvent of the etching liquid can be more stably removed from the substrate W as compared with a case in which the rinse liquid does not contain the organic dissolving agent. Accordingly, the residue of the organic solvent of the etching liquid is less liable to remain on the substrate W. Particularly, where the organic solvent of the etching liquid is water-insoluble and the water is used alone as the rinse liquid, the residue of the organic solvent of the etching liquid is more liable to remain on the substrate W. In this embodiment, in contrast, the organic dissolving agent having higher affinity for the organic solvent of the etching liquid is contained in the rinse liquid. Therefore, even if the organic solvent of the etching liquid is water-insoluble, the organic solvent of the etching liquid can be more stably removed from the substrate W.

In this embodiment, the organic dissolving agent is contained in the rinse liquid, so that wettability with the rinse liquid is improved as compared with the case in which the rinse liquid does not contain the organic dissolving agent. As a result, even with the substrate W formed with a fine pattern, the rinse liquid can be stably infiltrated into deep parts of the pattern. Therefore, the etching liquid can be stably removed from the deep parts of the pattern.

The first rinse liquid pipe 201 supplies the rinse liquid to the second nozzle 7. The first rinse liquid open/close valve 221 is provided in the first rinse liquid pipe 201. The first rinse liquid open/close valve 221 is accommodated in the fluid box 100B described with reference to FIG. 1. The controller 10 (control unit 11) sets the first rinse liquid open/close valve 221 in an open state when the rinse liquid is to be discharged from the second nozzle 7. The controller 10 (control unit 11) sets the first rinse liquid open/close valve 221 in a closed state when the discharge of the rinse liquid from the second nozzle 7 is to be stopped. The first rinse liquid pipe 201 and the first rinse liquid open/close valve 221 have substantially the same configurations as the etching liquid pipe 101 and the etching liquid open/close valve 102, respectively, and therefore will not be described in detail.

The controller 10 (control unit 11) controls the second nozzle moving unit 8 to move the second nozzle 7 vertically and horizontally. As shown in FIG. 2, the second nozzle moving unit 8 may have a second nozzle arm 81, a second nozzle base 82 and a second nozzle moving mechanism 83. Like the first nozzle moving mechanism 63, the second nozzle moving mechanism 83 has a rotation mechanism and a lift mechanism. The rotation mechanism of the second nozzle moving mechanism 83 rotates the second nozzle base 82 in forward and reverse directions about a third rotation axis AX3 extending vertically. The second nozzle arm 81, the second nozzle base 82 and the second nozzle moving mechanism 83 have substantially the same configurations as the first nozzle arm 61, the first nozzle base 62 and the first nozzle moving mechanism 63, respectively, and therefore will not be described in detail.

The second nozzle moving unit 8 moves the second nozzle 7 between a second retraction position and the treatment position. The second retraction position is a position outward of the liquid receiving portion 9 and different from the first retraction position of the first nozzle 5. Like the first nozzle 5, the second nozzle 7 discharges the rinse liquid toward the upper surface of the substrate W from a position (treatment position) opposed to the center of the upper surface of the substrate W.

The liquid receiving portion 9 surrounds the substrate holding unit 3 and the substrate rotating unit 4. The liquid receiving portion 9 receives the etching liquid and the rinse liquid expelled from the rotating substrate W. Specifically, the liquid receiving portion up/down movement unit 91 is controlled by the controller 10 (control unit 11) to move up and down the liquid receiving portion 9 between an upper position and a lower position. The liquid receiving portion up/down movement unit 91 includes, for example, an electric motor that is rotatable forward and reverse, and a ball screw mechanism. The upper position is a position above the lower position. The liquid receiving portion 9 surrounds the substrate W held by the substrate holding unit 3 when located at the upper position. During the treatment of the substrate W, the liquid receiving portion 9 is located at the upper position to receive the etching liquid and the rinse liquid expelled from the rotating substrate W.

With the liquid receiving portion 9 located at the lower position, the upper edge of the liquid receiving portion 9 is located at a lower level than the substrate W held by the substrate holding unit 3. The liquid receiving portion 9 is located at the lower position when the substrate W is to be loaded into the chamber 2a by the center robot CR described with reference to FIG. 1. Further, the liquid receiving portion 9 is located at the lower position when the substrate W is to be unloaded out of the chamber 2a by the center robot CR described with reference to FIG. 1.

The liquid receiving portion up/down movement unit 91 may be accommodated within the chamber 2a, or may be disposed outside the chamber 2a.

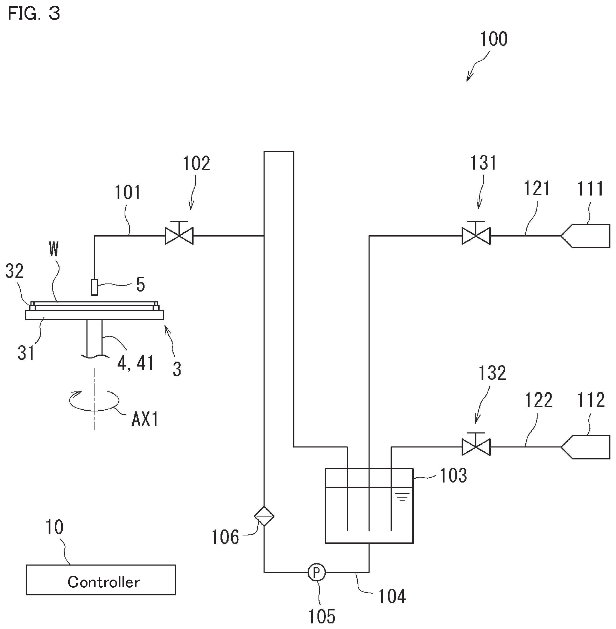

Referring next to FIG. 3, the substrate processing apparatus 100 of this embodiment will be described. FIG. 3 is a diagram showing the structure of a part of the substrate processing apparatus 100 of this embodiment. As shown in FIG. 3, the substrate processing apparatus 100 of this embodiment further includes a reservoir 103, a circulation pipe 104, a circulation pump 105, a circulation filter 106, a first constituent pipe 121, a first constituent open/close valve 131, a second constituent pipe 122, and a second constituent open/close valve 132. The reservoir 103, a part of the circulation pipe 104, the circulation pump 105, the circulation filter 106, the first constituent pipe 121, the first constituent open/close valve 131, the second constituent pipe 122 and the second constituent open/close valve 132 are accommodated in the fluid cabinet 100A described with reference to FIG. 1. Another part of the circulation pipe 104 is accommodated in the fluid box 100B described with reference to FIG. 1.

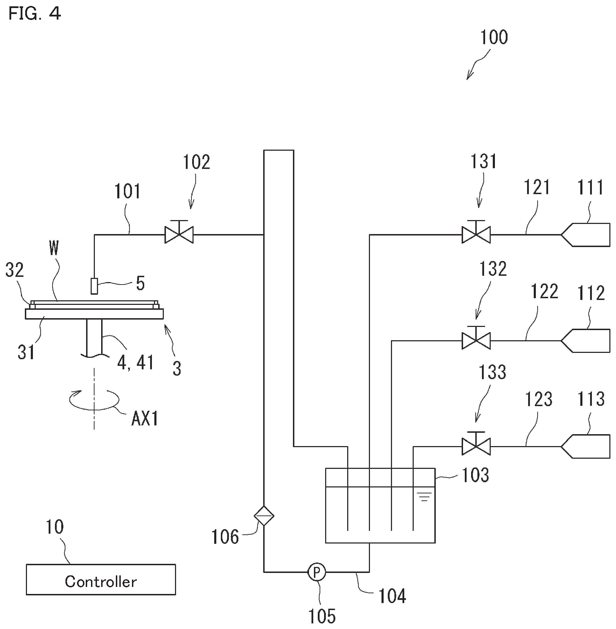

The reservoir 103 stores the etching liquid. Specifically, the chemical liquid, which is supplied from a first constituent supply source 111 through the first constituent pipe 121, is stored in the reservoir 103. Further, the organic solvent, which is supplied from a second constituent supply source 112 through the second constituent pipe 122, is stored in the reservoir 103. As a result, the chemical liquid and the organic solvent are mixed together in the reservoir 103, whereby the etching liquid is prepared. The first constituent supply source 111 may be equipment in a plant installed with the substrate processing apparatus 100. Similarly, the second constituent supply source 112 may also be equipment in the plant in which the substrate processing apparatus 100 is installed. However, the substrate processing apparatus 100 may be provided with at least one of the first constituent supply source 111 and the second constituent supply source 112. The same applies to a third constituent supply source 113 to be described later with reference to FIG. 4.

Specifically, the first constituent pipe 121 is a tubular member through which liquid flows, and the chemical liquid supplied from the first constituent supply source 111 flows through the first constituent pipe 121 to the reservoir 103. The first constituent open/close valve 131 is provided in the first constituent pipe 121. When the chemical liquid is to be supplied to the reservoir 103, the controller 10 (control unit 11) sets the first constituent open/close valve 131 in an open state. When the supply of the chemical liquid to the reservoir 103 is to be stopped, the controller 10 (control unit 11) sets the first constituent open/close valve 131 in a closed state.

The second constituent pipe 122 is a tubular member through which liquid flows, and the organic solvent supplied from the second constituent supply source 112 flows to the reservoir 103. The second constituent open/close valve 132 is provided in the second constituent pipe 122. When the organic solvent is to be supplied to the reservoir 103, the controller 10 (control unit 11) sets the second constituent open/close valve 132 in an open state. When the supply of the organic solvent to the reservoir 103 is to be stopped, the controller 10 (control unit 11) sets the second constituent open/close valve 132 in a closed state.

Specifically, the controller 10 (control unit 11) controls the first constituent open/close valve 131 and the second constituent open/close valve 132 so as to adjust the ratio of the chemical liquid and the organic solvent to a predetermined ratio. The first constituent open/close valve 131 and the second constituent open/close valve 132 each have substantially the same configuration as the etching liquid open/close valve 102 described with reference to FIG. 2 and, therefore, will not be described in detail.

The circulation pipe 104 is a tubular member through which liquid flows. One end (upstream end) and the other end (downstream end) of the circulation pipe 104 are connected to the reservoir 103.

The circulation pump 105 is provided in the circulation pipe 104. The circulation pump 105 feeds the etching liquid so that the etching liquid flows from the one end (upstream end) to the other end (downstream end) of the circulation pipe 104 through the circulation pipe 104. As a result, the etching liquid circulates through the circulation pipe 104 via the reservoir 103. The circulation pump 105 is controlled by the controller 10 (control unit 11).

The circulation filter 106 is provided in the circulation pipe 104. The circulation filter 106 removes foreign matter from the etching liquid flowing through the circulation pipe 104.

As shown in FIG. 3, one end (downstream end) of the etching liquid pipe 101 is connected to the first nozzle 5, and the other end (upstream end) of the etching liquid pipe 101 is connected to the circulation pipe 104. With the etching liquid open/close valve 102 open, the etching liquid flows into the etching liquid pipe 101 from the circulation pipe 104, and is supplied to the first nozzle 5 through the etching liquid pipe 101. As a result, the etching liquid is discharged from the first nozzle 5.

Here, the chemical liquid and the organic solvent will be described by way of example. The inventors of the present invention observed whether or not the chemical liquid and the organic solvent were separated from each other under Conditions 1 to 3 shown below in Table 1. There is a possibility that the chemical liquid is not infiltrated into the deep parts of the pattern if the chemical liquid and the organic solvent are separated from each other.

**Table 1**

| Condition | Etching liquid mixing ratio | Liquid separation |
|---|---|---|
| 1 | 49% HF:PGMEA = 1:15 | Not separated |
| 2 | DHF(1:100):PGMEA = 1:300 | Separated |
| 3 | DHF(1:100):PGMEA = 1:399 | Separated |

In an experiment performed under Condition 1, hydrofluoric acid having a concentration of 49% (49% HF) and PGMEA were prepared. Deionized water was used as a solvent for hydrofluoric acid. Then, 49% HF and PGMEA were mixed together at a ratio of 49% HF:PGMEA = 1:15 in a beaker. The total amount of 49% HF and PGMEA was 100 ml. As a result, 49% HF and PGMEA were not separated from each other in the beaker. That is, liquid separation did not occur.

In an experiment performed under Condition 2, diluted hydrofluoric acid (DHF) and PGMEA were prepared. Hydrofluoric acid diluted with deionized water (DIW) was used as the diluted hydrofluoric acid. The ratio between the hydrofluoric acid and the deionized water was HF:DIW = 1:100. Then, DHF and PGMEA were mixed together at a ratio of DHF:PGMEA = 1:300 in a beaker. The total amount of DHF and PGMEA was 100 ml. As a result, DHF and PGMEA were separated from each other in the beaker. That is, the liquid separation occurred.

In an experiment performed under Condition 3, DHF and PGMEA were prepared as in the experiment performed under Condition 2. Then, DHF and PGMEA were mixed together at a ratio of DHF:PGMEA = 1:399 in a beaker. The total amount of DHF and PGMEA was 100 ml. As a result, DHF and PGMEA were separated from each other in the beaker. That is, the liquid separation occurred.

Based on the experiments performed under Conditions 1 to 3, it was confirmed that the liquid separation is more liable to occur if the etching liquid has a lower hydrogen ion concentration.

Next, the inventors of the present invention observed whether or not the liquid separation occurred with the mixing ratio (ratio) of 49% HF (chemical liquid) and PGMEA (organic solvent) differently set. Specifically, the inventors of the present invention observed whether or not 49% HF (chemical liquid) and PGMEA (organic solvent) were separated from each other under Condition 4 and Condition 5 shown below in Table 2.

**Table 2**

| Condition | Etching liquid mixing ratio | Liquid separation |
|---|---|---|
| 4 | 49% HF:PGMEA = 1:300 | Not separated |
| 5 | 49% HF:PGMEA = 1:399 | Not separated |

In an experiment performed under Condition 4, 49% HF and PGMEA were mixed together at a ratio of 49% HF:PGMEA = 1:300 in a beaker. The total amount of 49% HF and PGMEA was 100 ml. As a result, the liquid separation did not occur.

In an experiment performed under Condition 5, 49% HF and PGMEA were mixed together at a ratio of 49% HF:PGMEA = 1:399 in a beaker. The total amount of 49% HF and PGMEA was 100 ml. As a result, the liquid separation did not occur.

Based on the experiments performed under Conditions 1, 4 and 5, it was confirmed that, even with the mixing ratio (ratio) of the chemical liquid and the organic solvent differently set, the liquid separation is made less liable to occur by increasing the hydrogen ion concentration of the etching liquid.

Referring next to FIG. 4, the substrate processing apparatus 100 of this embodiment will be described by way of another example. FIG. 4 is a diagram showing the structure of a part of the substrate processing apparatus 100 of this embodiment by way of another example. As shown in FIG. 4, the substrate processing apparatus 100 of this embodiment may further include a third constituent pipe 123 and a third constituent open/close valve 133.

In the example shown in FIG. 4, the first constituent supply source 111 supplies the first chemical liquid. The third constituent supply source 113 supplies the second chemical liquid. For example, the first chemical liquid and the second chemical liquid can both be acidic chemical liquids. For example, the first chemical liquid may be a chemical liquid containing hydrogen fluoride. Specifically, the first chemical liquid may be hydrofluoric acid (HF) or diluted hydrofluoric acid (DHF). The second chemical liquid may be hydrochloric acid (HCl). The second constituent supply source 112 supplies the organic solvent. In the example shown in FIG. 4, therefore, the first chemical liquid, the second chemical liquid and the organic solvent are mixed together in the reservoir 103, whereby the etching liquid is prepared. That is, the etching liquid contains the first chemical liquid, the second chemical liquid and the organic solvent.

The second chemical liquid is supplied to the third constituent pipe 123 from the third constituent supply source 113. The third constituent pipe 123 is a tubular member through which liquid flows, and the second chemical liquid flows through the third constituent pipe 123 to the reservoir 103. The third constituent open/close valve 133 is provided in the third constituent pipe 123. The third constituent open/close valve 133 starts and stops flow of the second chemical liquid through the third constituent pipe 123.

Specifically, the controller 10 (control unit 11) controls the open/close operations of the first constituent open/close valve 131, the second constituent open/close valve 132 and the third constituent open/close valve 133 so as to adjust the ratio of the first chemical liquid, the second chemical liquid and the organic solvent to a predetermined ratio. The third constituent open/close valve 133 has substantially the same configuration as the etching liquid open/close valve 102 described with reference to FIG. 2 and, therefore, will not be described in detail.

Here, the first chemical liquid, the second chemical liquid and the organic solvent will be described by way of example. The inventors of the present invention observed whether or not the liquid separation occurred under Conditions 6 to 8 shown below in Table 3.

**Table 3**

| Condition | Etching liquid mixing ratio | Liquid separation |
|---|---|---|
| 6 | 49% HF:HCl:PGMEA = 1:1:14 | Not separated |
| 7 | DHF(1:100):HCl:PGMEA = 1:1:300 | Not separated |
| 8 | DHF(1:100):HCl:PGMEA = 1:1:398 | Not separated |

In an experiment performed under Condition 6, 49% HF, HCl and PGMEA were prepared. Then, 49% HF, HCl and PGMEA were mixed together at a ratio of 49% HF:HCl:PGMEA = 1:1:14 in a beaker. The total amount of 49% HF, HCl and PGMEA was 100 ml. As a result, the liquid separation did not occur.

In an experiment performed under Condition 7, DHF, HCl and PGMEA were prepared. Then, DHF, HCl and PGMEA were mixed together at a ratio of DHF:HCl:PGMEA = 1:1:300 in a beaker. The total amount of DHF, HCl and PGMEA was 100 ml. As a result, the liquid separation did not occur unlike in the experiment performed under Condition 2.

In an experiment performed under Condition 8, DHF, HCl and PGMEA were prepared as in the experiment performed under Condition 7. Then, DHF, HCl and PGMEA were mixed together at a ratio of DHF:HCl:PGMEA = 1:1:398 in a beaker. The total amount of DHF, HCl and PGMEA was 100 ml. As a result, the liquid separation did not occur unlike in the experiment performed under Condition 3.

Based on the experiments performed under Conditions 6 to 8, it was confirmed that, even with the mixing ratio (ratio) of the chemical liquids and the organic solvent differently set, the liquid separation is less liable to occur if the etching liquid has a higher hydrogen ion concentration.

In the example shown in FIG. 4, the etching liquid is prepared by mixing the first chemical liquid, the second chemical liquid and the organic solvent, but the substrate processing apparatus 100 may be configured to prepare the etching liquid by mixing the chemical liquids, the organic solvent and the surfactant. Alternatively, the substrate processing apparatus 100 may be configured to prepare the etching liquid by mixing two or more kinds of the chemical liquids, the organic solvent and the surfactant. The surfactant may be supplied to the reservoir 103, for example, in the same manner as the second chemical liquid. The surfactant can be, for example, IPA. Where the surfactant is contained in the etching liquid, the infiltration of the etching liquid into the deep parts of the pattern can be improved.

Further, the substrate processing apparatus 100 may be configured to add the additive to the etching liquid. The additive may be supplied to the reservoir 103, for example, in the same manner as the second chemical liquid. The additive includes an additive that increases the hydrogen ion concentration of the etching liquid. For example, the additive can be perchloric acid (HClO₄), hydrogen iodide (HI), hydrogen bromide (HBr), hydrogen chloride (HCl), sulfuric acid (H₂SO₄), nitric acid (HNO₃), hydronium (H₃O⁺), oxalic acid (HO₂C₂O₂H), sulfurous acid (H₂SO₃), hydrogen sulfate ion (HSO₄⁻) or phosphoric acid (H₃PO₄). As described with reference to Tables 1 to 3, the liquid separation is made less liable to occur by increasing the hydrogen ion concentration of the etching liquid. Therefore, the addition of the additive can improve the infiltration of the etching liquid into the deep parts of the pattern. If the hydrogen ion concentration is increased by increasing the concentration of hydrogen fluoride to avoid the liquid separation, there is a possibility that the etching amount is increased to greater than an initially intended level. Where the additive is used, in contrast, the hydrogen ion concentration can be increased without increasing the concentration of hydrogen fluoride. Therefore, the etching amount is unlikely to be increased to greater than the initially intended level.

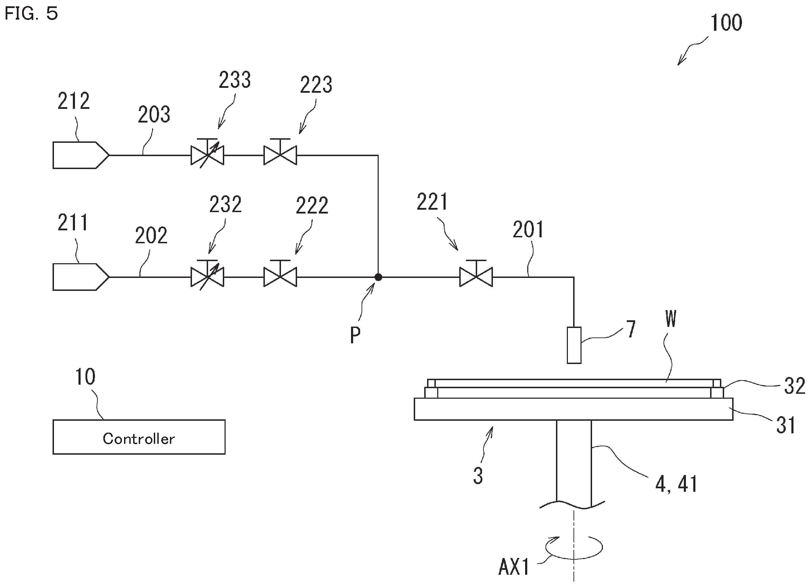

Referring next to FIG. 5, the substrate processing apparatus 100 of this embodiment will be described. FIG. 5 is a diagram showing the structure of another part of the substrate processing apparatus 100 of this embodiment. As shown in FIG. 5, the substrate processing apparatus 100 further includes a second rinse liquid pipe 202, a third rinse liquid pipe 203, a second rinse liquid open/close valve 222, a third rinse liquid open/close valve 223, a first flow rate regulation valve 232, and a second flow rate regulation valve 233. A part of the second rinse liquid pipe 202, a part of the third rinse liquid pipe 203, the second rinse liquid open/close valve 222, the third rinse liquid open/close valve 223, the first flow rate regulation valve 232 and the second flow rate regulation valve 233 are accommodated in the fluid box 100B described with reference to FIG. 1.

As shown in FIG. 5, one end (downstream end) of the first rinse liquid pipe 201 is connected to the second nozzle 7. One end (downstream end) of the second rinse liquid pipe 202 and one end (downstream end) of the third rinse liquid pipe 203 are connected to the other end (upstream end) of the first rinse liquid pipe 201. Hereinafter, a position at which the first rinse liquid pipe 201, the second rinse liquid pipe 202 and the third rinse liquid pipe 203 are connected to each other will be sometimes referred to as "connection point P."

The second rinse liquid pipe 202 supplies the water to the first rinse liquid pipe 201. In this embodiment, the first rinse liquid pipe 201 is an example of "first liquid pipe" and an example of "liquid pipe," and the second rinse liquid pipe 202 is an example of "second liquid pipe." Specifically, the second rinse liquid pipe 202 is a tubular member through which liquid flows. The water, which is supplied from a fourth constituent supply source 211, flows through the second rinse liquid pipe 202 to the connection point P. As a result, the water is supplied to the first rinse liquid pipe 201.

The third rinse liquid pipe 203 supplies the organic dissolving agent to the first rinse liquid pipe 201. In this embodiment, the third rinse liquid pipe 203 is an example of "third liquid pipe." Specifically, the third rinse liquid pipe 203 is a tubular member through which liquid flows. The organic dissolving agent, which is supplied from a fifth constituent supply source 212, flows through the third rinse liquid pipe 203 to the connection point P. As a result, the organic dissolving agent is supplied to the first rinse liquid pipe 201.

The first rinse liquid pipe 201 and the second rinse liquid pipe 202 may be constituted by a single tubular member. Alternatively, the first rinse liquid pipe 201 and the third rinse liquid pipe 203 may be constituted by a single tubular member.

The fourth constituent supply source 211 may be equipment in the plant in which the substrate processing apparatus 100 is installed. Similarly, the fifth constituent supply source 212 may be equipment in the plant in which the substrate processing apparatus 100 is installed. However, the substrate processing apparatus 100 may include at least one of the fourth constituent supply source 211 and the fifth constituent supply source 212.

The second rinse liquid open/close valve 222 is provided in the second rinse liquid pipe 202. The second rinse liquid open/close valve 222 is controlled by the controller 10 (control unit 11) to control the on/off of the supply of the water from the second rinse liquid pipe 202 to the first rinse liquid pipe 201. Specifically, the second rinse liquid open/close valve 222 can be opened and closed. With the second rinse liquid open/close valve 222 set in an open state, the water flows through the second rinse liquid pipe 202, and flows into the first rinse liquid pipe 201 through the connection point P.

The third rinse liquid open/close valve 223 is provided in the third rinse liquid pipe 203. The third rinse liquid open/close valve 223 is controlled by the controller 10 (control unit 11) to control the on/off of the supply of the organic dissolving agent from the third rinse liquid pipe 203 to the first rinse liquid pipe 201. Specifically, the third rinse liquid open/close valve 223 can be opened and closed. With the third rinse liquid open/close valve 223 set in an open state, the organic dissolving agent flows through the third rinse liquid pipe 203, and flows into the first rinse liquid pipe 201 through the connection point P.

Specifically, when the rinse liquid containing the water and the organic dissolving agent is to be discharged from the second nozzle 7, the controller 10 (control unit 11) sets the first rinse liquid open/close valve 221, the second rinse liquid open/close valve 222 and the third rinse liquid open/close valve 223 in the open state. As a result, the water and the organic dissolving agent flow into the first rinse liquid pipe 201 through the connection point P. Then, the water and the organic dissolving agent are mixed together in the first rinse liquid pipe 201. Thus, the rinse liquid containing the water and the organic dissolving agent is prepared, and the rinse liquid containing the water and the organic dissolving agent is discharged from the second nozzle 7. Hereinafter, the rinse liquid containing the water and the organic dissolving agent will be sometimes referred to as "mixed rinse liquid."

When the discharge of the rinse liquid from the second nozzle 7 is to be stopped, the controller 10 (control unit 11) sets the first rinse liquid open/close valve 221, the second rinse liquid open/close valve 222 and the third rinse liquid open/close valve 223 in the closed state.

In this embodiment, the controller 10 (control unit 11) causes the second nozzle 7 to discharge the mixed rinse liquid, and then causes the second nozzle 7 to discharge a rinse liquid containing only the water out of the water and the organic dissolving agent. Hereinafter, the rinse liquid containing only the water out of the water and the organic dissolving agent will be sometimes referred to as "water rinse liquid." When the water rinse liquid is to be discharged from the second nozzle 7, the controller 10 (control unit 11) sets the first rinse liquid open/close valve 221 and the second rinse liquid open/close valve 222 in the open state, and sets the third rinse liquid open/close valve 223 in the closed state.

The second rinse liquid open/close valve 222 and the third rinse liquid open/close valve 223 each have substantially the same configuration as the etching liquid open/close valve 102 described with reference to FIG. 2 and, therefore, will not be described in detail.

The first flow rate regulation valve 232 is provided in the second rinse liquid pipe 202. The first flow rate regulation valve 232 is controlled by the controller 10 (control unit 11) to regulate the flow rate (the flow rate per unit time) of the water to be supplied to the first rinse liquid pipe 201 from the second rinse liquid pipe 202.

Specifically, the first flow rate regulation valve 232 can adjust the opening degree thereof. The controller 10 (control unit 11) controls the opening degree of the first flow rate regulation valve 232 to regulate the flow rate of the water flowing through the second rinse liquid pipe 202. As a result, the flow rate of the water to be supplied to the connection point P from the second rinse liquid pipe 202 is regulated. The first flow rate regulation valve 232 can be, for example, a motor-driven needle valve.

The second flow rate regulation valve 233 is provided in the third rinse liquid pipe 203. The second flow rate regulation valve 233 is controlled by the controller 10 (control unit 11) to regulate the flow rate of the organic dissolving agent to be supplied to the first rinse liquid pipe 201 from the third rinse liquid pipe 203. The second flow rate regulation valve 233 has substantially the same configuration as the first flow rate regulation valve 232 and, therefore, will not be described in detail.

The controller 10 (control unit 11) controls the second flow rate regulation valve 233 to adjust the concentration of the organic dissolving agent in the mixed rinse liquid. Specifically, the controller 10 (control unit 11) controls the first flow rate regulation valve 232 and the second flow rate regulation valve 233 so as to adjust the ratio between the water and the organic dissolving agent to a predetermined ratio.

Here, the etching liquid and the rinse liquid will be described by way of example. The inventors of the present invention observed whether or not the liquid separation occurred when the etching liquids according to Conditions 1, 4 and 5 described with reference to Tables 1 and 2 and the rinse liquids shown in Table 4 were used. If the liquid separation occurs, there is a possibility that, for example, the etching liquid is not completely removed from the substrate W and the residue of the etching liquid remains on the substrate W. Specifically, the inventors of the present invention checked whether or not the liquid separation occurred when the rinse liquid containing DIW alone (water rinse liquid) was used as shown below in Table 4. Further, the inventors of the present invention checked whether or not the liquid separation occurred when the rinse liquids each prepared by mixing DIW and IPA (mixed rinse liquids) were used. Further, the inventors of the present invention observed whether or not the liquid separation occurred with the concentration of IPA differently set. In each of the experiments, the etching liquid and the rinse liquid were mixed together in a beaker. The total amount of the etching liquid and the rinse liquid was 100 ml.

**Table 4**

| Condition | DIW (100%) | DIW (90%) | DIW (80%) | DIW (75%) | DIW (70%) | DIW (60%) | DIW (50%) |
|---|---|---|---|---|---|---|---|
| | | IPA (10%) | IPA (20%) | IPA (25%) | IPA (30%) | IPA (40%) | IPA (50%) |
| 1 | Separated | - | Separated | Not separated | - | - | Not separated |
| 4 | Separated | - | Separated | Not separated | - | - | Not separated |
| 5 | Separated | - | - | Separated | Not separated | - | Not separated |

As shown in Table 4, where the IPA concentration was not lower than 25% when the etching liquid (49% HF:PGMEA = 1:15) according to Condition 1 was used, the liquid separation did not occur. Similarly, where the IPA concentration was not lower than 25% when the etching liquid (49% HF:PGMEA = 1:300) according to Condition 4 was used, the liquid separation did not occur. Where the IPA concentration was not lower than 30% when the etching liquid (49% HF:PGMEA = 1:399) according to Condition 5 was used, the liquid separation did not occur.

The inventors of the present invention observed whether or not the liquid separation occurred when the etching liquids according to Conditions 7 and 8 described with reference to Table 3 and the rinse liquids shown in Table 5 were used. Specifically, the inventors of the present invention checked whether or not the liquid separation occurred when the rinse liquid (water rinse liquid) containing DIW alone was used as shown below in Table 5. Further, the inventors of the present invention checked whether or not the liquid separation occurred when the rinse liquids each prepared by mixing DIW and IPA (mixed rinse liquids) were used. Further, the inventors of the present invention observed whether or not the liquid separation occurred with the concentration of IPA differently set. In each of the experiments, the etching liquid and the rinse liquid were mixed together in a beaker. The total amount of the etching liquid and the rinse liquid was 100 ml.

**Table 5**

| Condition | DIW (100%) | DIW (90%) | DIW (80%) | DIW (75%) | DIW (70%) | DIW (60%) | DIW (50%) |
|---|---|---|---|---|---|---|---|
| | | IPA (10%) | IPA (20%) | IPA (25%) | IPA (30%) | IPA (40%) | IPA (50%) |
| 7 | Separated | - | - | Separated | Separated | Not separated | Not separated |
| 8 | - | - | - | Separated | Separated | Not separated | Not separated |

Where the IPA concentration was not lower than 40% when the etching liquid (DHF (1:100):HCl:PGMEA = 1:1:300) according to Condition 7 was used, as shown in Table 5, the liquid separation did not occur. Similarly, where the IPA concentration was not lower than 40% when the etching liquid (DHF (1:100):HCl:PGMEA = 1:1:398) according to Condition 8 was used, the liquid separation did not occur.

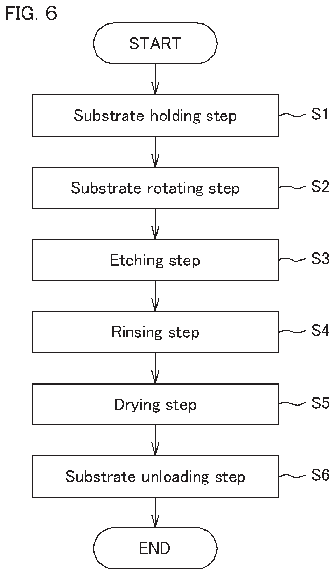

Referring next to FIGS. 1 to 6, the substrate processing apparatus 100 and a substrate processing method according to this embodiment will be described. FIG. 6 is a flowchart showing the substrate processing method of this embodiment. The substrate processing method shown in FIG. 6 is performed by the substrate processing apparatus 100 described with reference to FIGS. 1 to 5. Therefore, FIG. 6 shows an operation to be performed by the substrate processing apparatus 100 of this embodiment. More specifically, FIG. 6 shows a process sequence to be performed by the control unit 11 included in the substrate processing apparatus 100 of this embodiment. The process shown in FIG. 6 includes Steps S1 to S6.

The process shown in FIG. 6 is started in response to the loading of the substrate W into the chamber 2a by the center robot CR. Upon the start of the process shown in FIG. 6, the control unit 11 controls the center robot CR and the substrate holding unit 3 to cause the substrate holding unit 3 to horizontally hold the substrate W (Step S1: substrate holding step). Specifically, the control unit 11 controls the center robot CR to place the substrate W on the chuck members 32, and then moves the center robot CR out of the chamber 2a. When the substrate W is placed on the chuck members 32, the control unit 11 controls the chuck members 32 to cause the chuck members 32 to clamp the substrate W.

With the substrate W horizontally held by the substrate holding unit 3, the control unit 11 controls the substrate rotating unit 4 to rotate the substrate W and the substrate holding unit 3 together (Step S2: substrate rotating step). After the center robot CR is moved out of the chamber 2a, the control unit 11 controls the liquid receiving portion up/down movement unit 91 to move the liquid receiving portion 9 from the lower position to the upper position. Further, the control unit 11 controls the first nozzle moving unit 6 to move the first nozzle 5 from the first retraction position to the treatment position.

When the rotation speed of the substrate W reaches a predetermined rotation speed, the control unit 11 performs the etching process. Specifically, the control unit 11 causes the first nozzle 5 to discharge the etching liquid toward the substrate W rotating while being held by the substrate holding unit 3 (Step S3: etching step). As a result, the liquid film of the etching liquid is formed on the upper surface of the substrate W. Specifically, the control unit 11 switches the etching liquid open/close valve 102 from the closed state to the open state. As a result, the etching liquid is supplied to the first nozzle 5 through the etching liquid pipe 101 to be thereby discharged from the first nozzle 5.

After a lapse of a predetermined period from the start of the discharge of the etching liquid from the first nozzle 5, the control unit 11 switches the etching liquid open/close valve 102 from the open state to the closed state to thereby stop the discharge of the etching liquid. Thereafter, the control unit 11 performs the rinsing process. Specifically, the control unit 11 causes the second nozzle 7 to discharge the rinse liquid toward the substrate W rotating while being held by the substrate holding unit 3 to remove the etching liquid from the substrate W (Step S4). As a result, the liquid film of the etching liquid is replaced with the liquid film of the rinse liquid on the substrate W.

Specifically, after the discharge of the etching liquid is stopped, the control unit 11 controls the first nozzle moving unit 6 to move the first nozzle 5 from the treatment position to the first retraction position. Further, the control unit 11 controls the second nozzle moving unit 8 to move the second nozzle 7 from the second retraction position to the treatment position. Thereafter, the control unit 11 switches the first to third rinse liquid open/close valves 221 to 223 from the closed state to the open state. As a result, the rinse liquid containing the water and the organic dissolving agent (mixed rinse liquid) is supplied to the substrate W from the second nozzle 7.

After a lapse of a predetermined period from the start of the supply of the rinse liquid from the second nozzle 7, the control unit 11 switches the first to third rinse liquid open/close valves 221 to 223 from the open state to the closed state to stop the discharge of the rinse liquid. After the stop of the discharge of the rinse liquid, the control unit 11 controls the second nozzle moving unit 8 to move the second nozzle 7 from the treatment position to the second retraction position.

After the stop of the discharge of the rinse liquid, the control unit 11 performs the drying process (Step S5). Specifically, the control unit 11 controls the substrate rotating unit 4 to increase the rotation speed of the substrate W to rotate the substrate W at a higher rotation speed. As a result, the rinse liquid is scattered off from the substrate W, whereby the substrate W is dried.

After a lapse of a predetermined period from the increase of the rotation speed of the substrate W, the control unit 11 controls the substrate rotating unit 4 to stop the rotation of the substrate W. Thereafter, the control unit 11 controls the center robot CR to unload the substrate W out of the chamber 2a (Step S6). As a result, the process shown in FIG. 6 ends.

Specifically, after the stop of the rotation of the substrate W, the control unit 11 controls the liquid receiving portion up/down movement unit 91 to move the liquid receiving portion 9 from the upper position to the lower position. Further, the control unit 11 controls the substrate holding unit 3 to cause the chuck members 32 to unclamp the substrate W. Thereafter, the control unit 11 controls the center robot CR to unload the substrate W out of the chamber 2a.

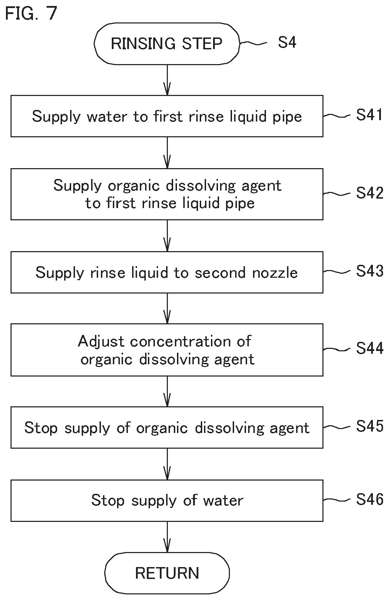

Referring next to FIGS. 1 to 9, the rinsing step (Step S4) shown in FIG. 6 will be described by way of example. FIG. 7 is a flowchart showing the rinsing step (Step S4 in FIG. 6) by way of example.

Upon the start of the rinsing step, as shown in FIG. 7, the control unit 11 switches the second rinse liquid open/close valve 222 from the closed state to the open state to supply the water from the second rinse liquid pipe 202 to the first rinse liquid pipe 201 (Step S41). Further, the control unit 11 switches the third rinse liquid open/close valve 223 from the closed state to the open state to supply the organic dissolving agent to the first rinse liquid pipe 201 from the third rinse liquid pipe 203 (Step S42). Then, the control unit 11 switches the first rinse liquid open/close valve 221 from the closed state to the open state to supply the mixed rinse liquid (the rinse liquid containing the water and the organic dissolving agent) to the second nozzle 7 from the first rinse liquid pipe 201 (Step S43). As a result, the mixed rinse liquid is discharged from the second nozzle 7.

In the example shown in FIG. 7, the second rinse liquid open/close valve 222, the third rinse liquid open/close valve 223 and the first rinse liquid open/close valve 221 are switched from the closed state to the open state in this order, but the order of the switching of the first to third rinse liquid open/close valves 221 to 223 from the closed state to the open state is not limited to the order shown in FIG. 7. For example, the first rinse liquid open/close valve 221, the second rinse liquid open/close valve 222 and the third rinse liquid open/close valve 223 may be switched from the closed state to the open state in this order. Further, the control unit 11 may simultaneously switch the first to third rinse liquid open/close valves 221 to 223 from the closed state to the open state, or may switch at least two of the first to third rinse liquid open/close valves 221 to 223 from the closed state to the open state at different times.

In this embodiment, after a lapse of a predetermined period from the start of the discharge of the rinse liquid (mixed rinse liquid), the control unit 11 performs a concentration adjusting process to adjust the concentration of the organic dissolving agent (Step S44: concentration adjusting step). The concentration adjusting step includes a step of controlling the second flow rate regulation valve 233 to regulate the flow rate of the organic dissolving agent to be supplied to the first rinse liquid pipe 201 so that the concentration of the organic dissolving agent is lower at the end of the discharge of the rinse liquid from the second nozzle 7 than at the start of the discharge of the rinse liquid from the second nozzle 7. The concentration of the organic dissolving agent may be zero at the end of the discharge of the rinse liquid from the second nozzle 7.

In this embodiment, the control unit 11 controls the third rinse liquid open/close valve 223 to stop the supply of the organic dissolving agent during the discharge of the rinse liquid (mixed rinse liquid) (Step S45). Specifically, the control unit 11 switches the third rinse liquid open/close valve 223 from the open state to the closed state during the discharge of the rinse liquid (mixed rinse liquid). As a result, the supply of the organic dissolving agent to the first rinse liquid pipe 201 is stopped during the discharge of the rinse liquid (mixed rinse liquid). After the stop of the supply of the organic dissolving agent, the water rinse liquid (the rinse liquid containing only the water out of the water and the organic dissolving agent) is supplied from the second nozzle 7 to the substrate W.

After a lapse of a predetermined period from the stop of the supply of the organic dissolving agent, the control unit 11 switches the second rinse liquid open/close valve 222 from the open state to the closed state to stop the supply of the water to the first rinse liquid pipe 201 (Step S46). Further, the control unit 11 switches the first rinse liquid open/close valve 221 from the open state to the closed state. As a result, the discharge of the rinse liquid (water rinse liquid) from the second nozzle 7 is stopped, and the process shown in FIG. 7 ends.

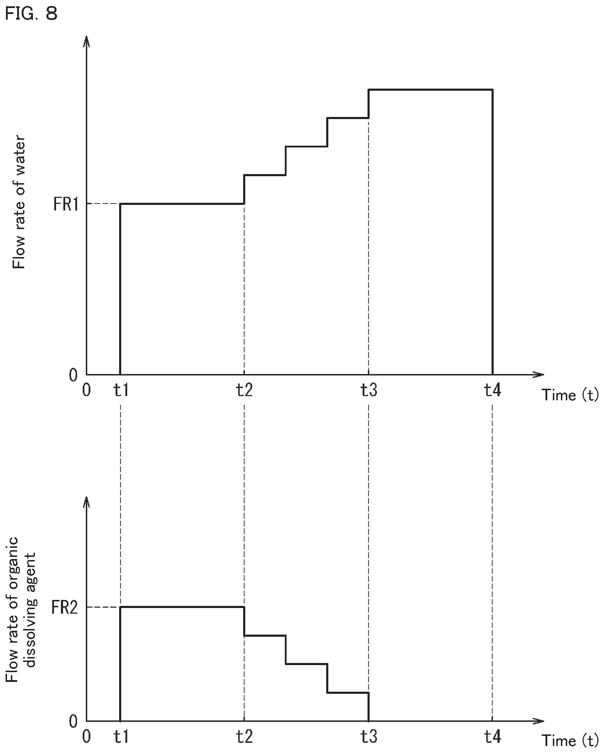

Referring next to FIG. 8, the step of adjusting the concentration of the organic dissolving agent (Step S44 in FIG. 7) and the step of stopping the supply of the organic dissolving agent during the discharge of the rinse liquid (Step S45 in FIG. 7) will be described by way of example.

FIG. 8 is a diagram showing the flow rate of the rinse liquid by way of example. Specifically, an upper graph in FIG. 8 shows the flow rate of the water. A lower graph in FIG. 8 shows the flow rate of the organic dissolving agent. In the upper graph in FIG. 8, the abscissa represents time, and the ordinate represents the flow rate of the water. In the lower graph in FIG. 8, the abscissa represents time, and the ordinate represents the flow rate of the organic dissolving agent.

As shown in FIG. 8, the control unit 11 may control the second flow rate regulation valve 233 so as to reduce the flow rate of the organic dissolving agent stepwise during the discharge of the rinse liquid, so that the concentration of the organic dissolving agent is reduced stepwise during the discharge of the rinse liquid.

Specifically, the control unit 11 switches the first to third rinse liquid open/close valves 221 to 223 from the closed state to the open state at a time t1. As a result, the water is supplied from the second rinse liquid pipe 202 to the first rinse liquid pipe 201 and, at the same time, the organic dissolving agent is supplied from the third rinse liquid pipe 203 to the first rinse liquid pipe 201. During a period from the time t1 to a time t2, the control unit 11 controls the first flow rate regulation valve 232 so that the flow rate of the water is kept constant at a flow rate FR1. During the period from the time t1 to the time t2, the control unit 11 controls the second flow rate regulation valve 233 so that the flow rate of the organic dissolving agent is kept constant at a flow rate FR2.

The control unit 11 starts the concentration adjusting step at the time t2. Specifically, during a period from the time t2 to a time t3, the control unit 11 controls the second flow rate regulation valve 233 so that the flow rate of the organic dissolving agent is reduced stepwise from the flow rate FR2. As a result, the concentration of the organic dissolving agent in the rinse liquid to be discharged from the second nozzle 7 is reduced stepwise.

In this embodiment, upon the start of the concentration adjusting step, the control unit 11 controls the first flow rate regulation valve 232 to increase the flow rate of the water stepwise from the flow rate FR1 according to the stepwise reduction of the flow rate of the organic dissolving agent. As a result, the flow rate of the rinse liquid to be discharged from the second nozzle 7 is kept constant. Further, the residue of the organic solvent of the etching liquid remaining on the substrate W can be removed from the substrate W by increasing the flow rate of the water.

At the time t3, the control unit 11 controls the third rinse liquid open/close valve 223 to stop the supply of the organic dissolving agent. Thereafter, the control unit 11 controls the second rinse liquid open/close valve 222 to stop the supply of the water at a time t4. Therefore, the water rinse liquid (the rinse liquid containing only the water out of the water and the organic dissolving agent) is discharged from the second nozzle 7 during a period from the time t3 to the time t4.

The concentration adjusting step may be started, for example, at a time when the organic solvent of the etching liquid is substantially removed from the substrate W. For example, the time when the organic solvent of the etching liquid is substantially removed from the substrate W is experimentally determined.

In the example shown in FIG. 8, the flow rate of the organic dissolving agent is reduced in three steps, but the flow rate of the organic dissolving agent may be reduced in a single step or in two steps. Alternatively, the flow rate of the organic dissolving agent may be reduced in four or more steps.

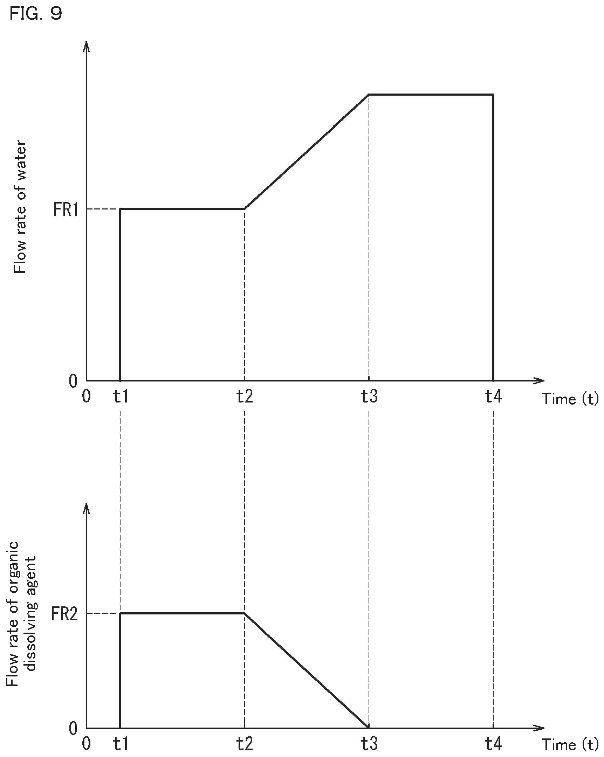

Referring next to FIG. 9, the step of adjusting the concentration of the organic dissolving agent (Step S44 in FIG. 7) and the step of stopping the supply of the organic dissolving agent during the discharge of the rinse liquid (Step S45 in FIG. 7) will be described by way of another example.

FIG. 9 is a diagram showing the flow rate of the rinse liquid by way of another example. Specifically, an upper graph in FIG. 9 shows the flow rate of the water. A lower graph in FIG. 9 shows the flow rate of the organic dissolving agent. In the upper graph in FIG. 9, the abscissa represents time, and the ordinate represents the flow rate of the water. In the lower graph in FIG. 9, the abscissa represents time, and the ordinate represents the flow rate of the organic dissolving agent.

As shown in FIG. 9, the control unit 11 may control the second flow rate regulation valve 233 so as to gradually reduce the flow rate of the organic dissolving agent during the discharge of the rinse liquid, so that the concentration of the organic dissolving agent is gradually reduced during the discharge of the rinse liquid.

Specifically, the control unit 11 controls the second flow rate regulation valve 233 to gradually reduce the flow rate of the organic dissolving agent during the period from the time t2 to the time t3. As a result, the concentration of the organic dissolving agent in the rinse liquid to be discharged from the second nozzle 7 is gradually reduced.

In this embodiment, upon the start of the concentration adjusting step, the control unit 11 controls the first flow rate regulation valve 232 to gradually increase the flow rate of the water according to the reduction of the flow rate of the organic dissolving agent. As a result, the flow rate of the rinse liquid to be discharged from the second nozzle 7 is kept constant. Further, the residue of the organic solvent of the etching liquid remaining on the substrate W can be removed from the substrate W by increasing the flow rate of the water.

With reference to FIGS. 1 to 9, the embodiment of the present invention has thus been described. According to this embodiment, the etching liquid can be infiltrated into the deep parts of the pattern formed on the upper surface of the substrate W.

According to this embodiment, the supply amount of the organic dissolving agent can be reduced during the rinsing step. This makes it possible to reduce the amount of the organic dissolving agent used, thereby reducing environmental loads.

According to this embodiment, the supply of the organic dissolving agent can be stopped during the rinsing step. This makes it possible to reduce the amount of the organic dissolving agent used, thereby reducing the environmental loads.

In this embodiment, the supply of the organic dissolving agent is stopped after the flow rate of the organic dissolving agent is reduced, but the supply of the organic dissolving agent may be stopped without reducing the flow rate of the organic dissolving agent during the discharge of the rinse liquid. In this embodiment, the supply of the organic dissolving agent is stopped during the discharge of the rinse liquid, but this step may be omitted. For example, the supply of the organic dissolving agent may be continued until the end of the rinsing step after the reduction of the flow rate of the organic dissolving agent.

While the embodiment of the present invention has thus been described with reference to the drawings (FIGS. 1 to 9), the present invention is not limited to the embodiment described above, but various modifications can be made without departing from the scope of the present invention. The components disclosed in the examples of the embodiment described above can be modified as appropriate. For example, a component selected from the components shown in one example of the embodiment may be additionally provided in another example of the embodiment, or some of the components shown in one example of the embodiment may be deleted from the one example.

The drawings schematically mainly show the components for easy understanding of the present invention, and the thicknesses, the lengths, the number, the spacings and the like of the components shown in the drawings may differ from actual ones for convenience of the preparation of the drawings. Further, the components shown in the embodiment described above are provided by way of example but not by way of limitation. Needless to say, various modifications can be made substantially without departing from the scope of the effects of the present invention.

In the embodiment described with reference to FIGS. 1 to 9, the drying step (Step S5 in FIG. 6) is performed after the rinsing step (Step S4 in FIG. 6), but a replacing step may be performed between the rinsing step and the drying step. In the replacing step, the liquid film of the water is replaced with a liquid film of IPA on the substrate W.

In the embodiment described with reference to FIGS. 1 to 9, the substrate W is dried by the highspeed rotation thereof in the drying step (Step S5 in FIG. 6), but the drying step is not limited to the highspeed rotation. For example, the substrate processing apparatus 100 may be configured to dry the substrate W by spraying an inert gas on the substrate W after the replacing step. Alternatively, the substrate processing apparatus 100 may be configured to dry the substrate W by keeping the substrate W in an inert gas atmosphere after the replacing step.

In the embodiment described with reference to FIGS. 1 to 9, the first rinse liquid pipe 201, the second rinse liquid pipe 202 and the third rinse liquid pipe 203 are connected together at the single point (connection point P), but the second rinse liquid pipe 202 and the third rinse liquid pipe 203 may be connected to the first rinse liquid pipe 201 at different points, respectively.

In the embodiment described with reference to FIGS. 1 to 9, the first rinse liquid pipe 201, the second rinse liquid pipe 202 and the third rinse liquid pipe 203 are directly connected to each other. Alternatively, the first rinse liquid pipe 201, the second rinse liquid pipe 202 and the third rinse liquid pipe 203 may be connected to each other via a manifold. Where the manifold is used, the water and the organic dissolving agent may be mixed in the manifold.

In the embodiment described with reference to FIGS. 1 to 9, the constituents of the etching liquid are mixed together in the fluid cabinet 100A. Alternatively, the constituents of the etching liquid may be mixed together in a pipe through which the etching liquid is supplied to the first nozzle 5.

In the embodiment described with reference to FIGS. 1 to 9, the first nozzle 5 discharges the etching liquid from the position opposed to the center of the upper surface of the substrate W. Alternatively, the first nozzle 5 may discharge the etching liquid from positions opposed to a plurality of positions aligned radially of the substrate W, or may discharge the etching liquid while being moved above the substrate W. Further, the first nozzle 5 may discharge the etching liquid from the position opposed to the center of the substrate W and from a position opposed to a peripheral portion of the substrate W.

In the embodiment described with reference to FIGS. 1 to 9, the substrate processing apparatus 100 includes the first nozzle 5 and the second nozzle 7. Alternatively, the substrate processing apparatus 100 may include a single nozzle that selectively discharges at least one of the etching liquid and the rinse liquid. In other words, the substrate processing apparatus 100 may include a single nozzle that discharges the etching liquid and the rinse liquid exclusively from each other.

In the embodiment described with reference to FIGS. 1 to 9, the substrate holding unit 3 has a clamp-type chuck mechanism, but the substrate holding unit 3 is not limited to the clamp-type chuck mechanism. For example, the substrate holding unit 3 may have a vacuum-type chuck mechanism.

The present invention is useful for substrate processing apparatuses and methods.

This application claims the benefit of priority to Japanese Patent Application No. 2024-010075 filed on January 26, 2024, the disclosure of which is incorporated herein in its entirety by reference.

## Claims

1. A substrate processing apparatus comprising:
a substrate holding unit that horizontally holds a substrate;
a substrate rotating unit that rotates the substrate and the substrate holding unit together;
a first nozzle that discharges an etching liquid toward the substrate rotating while being held by the substrate holding unit; and
a second nozzle that discharges a rinse liquid toward the substrate rotating while being held by the substrate holding unit to remove the etching liquid from the substrate;
wherein the etching liquid comprises an organic solvent and a chemical liquid;
wherein the rinse liquid comprises an organic dissolving agent and water;
wherein the organic dissolving agent has higher affinity for the organic solvent than the water does.

2. The substrate processing apparatus according to claim 1, wherein the organic solvent is water-insoluble.

3. The substrate processing apparatus according to claim 1 or 2, wherein the organic solvent has a smaller relative dielectric constant than the chemical liquid.

4. The substrate processing apparatus according to any one of claims 1 to 3,
wherein the etching liquid comprises, as the organic solvent, a first organic solvent and a second organic solvent different from the first organic solvent,
wherein the first organic solvent and the second organic solvent have different relative dielectric constants.

5. The substrate processing apparatus according to any one of claims 1 to 4, wherein the etching liquid further comprises a surfactant.

6. The substrate processing apparatus according to any one of claims 1 to 5, wherein the etching liquid further comprises an additive that increases a hydrogen ion concentration of the etching liquid.

7. The substrate processing apparatus according to any one of claims 1 to 6, wherein the chemical liquid is an acidic chemical liquid.

8. The substrate processing apparatus according to any one of claims 1 to 7,
wherein the etching liquid comprises, as the chemical liquid, a first chemical liquid and a second chemical liquid different from the first chemical liquid,
wherein the first chemical liquid and the second chemical liquid are both acidic chemical liquids.

9. The substrate processing apparatus according to any one of claims 1 to 8, wherein a concentration of the organic dissolving agent in the rinse liquid is not lower than 25%.

10. The substrate processing apparatus according to any one of claims 1 to 9, further comprising:
a first liquid pipe to supply the rinse liquid to the second nozzle;
a second liquid pipe to supply the water to the first liquid pipe;
a third liquid pipe to supply the organic dissolving agent to the first liquid pipe;
a flow rate regulation valve provided in the third liquid pipe to regulate a flow rate of the organic dissolving agent to be supplied to the first liquid pipe from the third liquid pipe; and
a controller that controls the flow rate regulation valve to adjust the concentration of the organic dissolving agent in the rinse liquid;
wherein the controller controls the flow rate regulation valve so that the concentration of the organic dissolving agent is lower at the end of the discharge of the rinse liquid from the second nozzle than at the start of the discharge of the rinse liquid from the second nozzle.

11. The substrate processing apparatus according to claim 10, wherein the controller controls the flow rate regulation valve so that the concentration of the organic dissolving agent is reduced stepwise or gradually during the discharge of the rinse liquid.

12. The substrate processing apparatus according to claim 10 or 11, further comprising an open/close valve provided in the third liquid pipe and configured to start and stop supply of the organic dissolving agent from the third liquid pipe to the first liquid pipe,
wherein the controller controls the open/close valve to stop the supply of the organic dissolving agent during the discharge of the rinse liquid.

13. A substrate processing method comprising:
a substrate holding step of horizontally holding a substrate;
a substrate rotating step of rotating the substrate;
an etching step of discharging an etching liquid from a first nozzle toward the rotating substrate; and
a rinsing step of discharging a rinse liquid from a second nozzle toward the rotating substrate to remove the etching liquid from the substrate;
wherein the etching liquid comprises an organic solvent and a chemical liquid;
wherein the rinse liquid comprises an organic dissolving agent and water;
wherein the organic dissolving agent has higher affinity for the organic solvent than the water does.

14. The substrate processing method according to claim 13, wherein the rinsing step comprises:
a step of supplying the water to a liquid pipe to supply the rinse liquid to the second nozzle;
a step of supplying the organic dissolving agent to the liquid pipe; and
a concentration adjusting step of regulating a flow rate of the organic dissolving agent to be supplied to the liquid pipe so that a concentration of the organic dissolving agent is lower at the end of the discharge of the rinse liquid from the second nozzle than at the start of the discharge of the rinse liquid from the second nozzle.

15. The substrate processing method according to claim 14, wherein the flow rate of the organic dissolving agent is regulated so that the concentration of the organic dissolving agent is reduced stepwise or gradually during the discharge of the rinse liquid in the concentration adjusting step.

16. The substrate processing method according to claim 14 or 15, further comprising a step of stopping the supply of the organic dissolving agent to the liquid pipe during the discharge of the rinse liquid.
